Europäisches Patentamt

European Patent Office

Office européen des brevets

(11) Numéro de publication: **0 266 252 B1**

# (12) FASCICULE DE BREVET EUROPEEN

(45) Date de publication de fascicule du brevet: **02.09.92**  (51) Int. Cl.⁵: **G02F 1/133**, H01L 21/84

(21) Numéro de dépôt: **87402274.2**

(22) Date de dépôt: **13.10.87**

(54) **Ecran de visualisation électrooptique à transistors de commande et procédé de réalisation.**

(30) Priorité: **14.10.86 FR 8614256**

(43) Date de publication de la demande:
**04.05.88 Bulletin  88/18**

(45) Mention de la délivrance du brevet:
**02.09.92 Bulletin  92/36**

(84) Etats contractants désignés:
**BE CH DE FR LI**

(56) Documents cités:
**EP-A- 0 125 666**

**PATENT ABSTRACTS OF JAPAN, vol. 9,
no.185 (E-332)[1908], 31 juillet 1985; & JP-
A-60 54 478**

**PATENT ABSTRACTS OF JAPAN, vol. 10, no.
97 (P-446)[2154], 15 avril 1986; & JP-A-60 230
634**

(73) Titulaire: **THOMSON GRAND PUBLIC
74, rue du Surmelin
F-75020 Paris(FR)**

(72) Inventeur: **Chartier, Eric
THOMSON-CSF SCPI 19, avenue de Messine
F-75008 Paris(FR)**
Inventeur: **Hareng, Michel
THOMSON-CSF SCPI 19, avenue de Messine
F-75008 Paris(FR)**

(74) Mandataire: **Lepercque, Jean et al
THOMSON-CSF SCPI
F-92045 PARIS LA DEFENSE CEDEX 67(FR)**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

Rank Xerox (UK) Business Services

## Description

L'invention concerne un écran de visualisation électrooptique à transistors de commande et plus particulièrement un écran plat dans lequel la commande de chaque élément d'image à visualiser se fait à l'aide d'un transistor de commande. Elle est applicable à la réalisation d'écrans plats à cristal liquide de grande surface dont les points de commande se font par intégration sous forme de couches minces. Le procédé selon l'invention permet une réalisation d'un écran par un procédé redondant et un nombre minimal de masques de lithographie:

Comme il est connu, ces écrans comportent généralement un grand nombre de points élémentaires ou éléments d'image de forme carrée ou rectangulaire. Ces éléments d'image doivent être adressés individuellement. La définition de l'écran est fonction du nombre de points susceptibles de recevoir une information. La commande de chaque point se fait par application d'un champ électrique à travers le cristal liquide. Pour la visualisation d'informations alphanumériques ou graphiques, il a été proposé des affichages de type matriciel. Chaque élément d'image est alors défini par l'intersection de deux réseaux de conducteurs orthogonaux appelés lignes et colonnes.

L'adressage de ces écrans matriciels de visualisation revêt une importance de plus en plus considérable au fur et à mesure qu'on cherche à en augmenter la définition, c'est-à-dire le nombre de points élémentaires d'image.

Les points élémentaires étant adressés séquentiellement ligne par ligne, le nombre de lignes pouvant être adressées est en général limité par les caractéristiques de l'effet électrooptique du cristal liquide utilisé. La possibilité d'adresser un grand nombre de lignes (>100) se fait alors au détriment des autres caractéristiques de l'écran (diminution du contraste et de l'angle de vue). Pour améliorer les performances de ces écrans, on peut mettre en série avec chaque point image (constituant une capacité) un transistor ou un élément non linéaire. L'ensemble se comporte alors comme un élément mémoire.

Actuellement, les exigences de la technique en matière d'écran de visualisation portent sur une meilleure définition de l'image. Dans le cas des écrans du type à affichage matriciel, on est alors amené à concevoir des dispositifs comportant un nombre élevé de lignes ou de colonnes d'adressage. Leur nombre peut aller jusqu'à 1024 voire au-delà. Ceci augmente d'autant le nombre de transistors de commande. Pour la fabrication en série, il est nécessaire notamment d'obtenir un rendement élevé, une bonne reproductibilité, et une grande stabilité de ces composants. Il est en outre nécessaire d'adapter, et ce également avec une bonne reproductibilité, les caractéristiques électriques du composant à celle de la cellule associée.

Une manière maintenant usuelle de résoudre ce problème consiste à réaliser cet adressage à l'aide d'une matrice de transistors en couches minces : ceci revient à coupler directement l'effet électrooptique sur un "circuit intégré" géant mais de basse résolution, chargé d'assurer les fonctions d'aiguillage et de mémorisation de l'information.

Cette approche présente des difficultés technologiques certaines, dans la réalisation tant des transistors en couches minces que des niveaux conducteurs d'interconnexion ; en particulier, il est impératif que, parmi les très nombreux croisements entre les lignes et les colonnes du réseau d'interconnexion, aucun ne soit défectueux.

En effet, selon une technique usuelle, les transistors sont situés aux points de croisement de conducteurs de ligne et de conducteurs de colonne isolés entre eux, de telle façon qu'une différence de potentiel appropriée, appliquée entre une ligne et une colonne, détermine la conduction du transistor connecté entre cette ligne et ce colonne.

La réalisation d'une matrice de transistors en film mince nécessite en général quatre étapes de photographie tel que cela est décrit par exemple dans l'article "Amorphous SiTFT active matrix LC TV" de N.YAMANO publiée dans Japan Display 83, Kobe, en 1983, page 356″. Ces transistors sont réalisés dans la structure étagée inverse.

L'invention concerne un écran de visualisation et plus particulière un transistor de commande d'un tel écran dont le procédé de réalisation qui, tout en ne nécessitant que quatre niveaux de masquage, permet à la fois la redondance des lignes et des colonnes et des prises de contacts de même nature en bout de lignes et de colonnes.

L'invention concerne donc un écran de visualisation électrooptique à transistors de commande comportant :
- une première et une deuxième lames parallèles enserrant un matériau électrooptique ;
  - la première lame étant munie sur sa face en contact avec le matériau électrooptique d'une matrice d'éléments image arrangés en lignes et colonnes, d'électrodes de commande de lignes à raison d'une électrode associée à chaque ligne d'éléments image de ladite matrice et disposée parallèlement à cette ligne d'éléments image, et de transistors de commande à raison d'un transistor par élément image couplant celui-ci à ladite électrode de commande de ligne ;
  - la deuxième lame étant munie sur sa face en contact avec le matériau électrooptique d'au moins une électrode;

caractérisé en ce qu'il comporte en outre sur la première lame :

- des éléments d'électrodes de colonnes interrompus à chaque croisement d'une ligne et d'une colonne ;
- une couche de matériau isolant recouvrant la face de la première lame dans les zones non couvertes par les électrodes de lignes, les éléments d'électrodes de colonnes et les éléments image, et recouvrant aussi les électrodes de lignes et les éléments d'électrodes de colonnes sauf des zones d'interconnexion situées au voisinage de chaque point de croisement de ligne et colonne ;
- une mésa par point de croisement de ligne et de colonne en matériau semiconducteur recouvrant une partie d'une électrode de ligne ;
- un élément conducteur (ou drain de transistor) reliant la mésa à l'élément image ;
- au moins une électrode de colonnes reliées à la mésa et connectée par les zones d'interconnexion aux éléments d'électrodes de colonne ;
- des élements d'électrodes de lignes superposés à la couche de matériau isolant, interrompus à chaque croisement d'une ligne et d'une colonne et connectés par les zones d'interconnexion aux électrodes de lignes situées de l'autre côté de la couche d'isolant.

L'invention concerne également un procédé de réalisation d'un écran de visualisation électrooptique à transistors de commande selon la revendication 1, caractérisé en ce qu'il comporte les étapes suivantes :

a) une première étape de dépôt d'une couche d'oxyde d'indium sur une face d'un substrat, d'oxydation de cette couche, puis de recuit à haute température.

b) une deuxième étape de dépôt d'une première couche de métal sur ladite couche d'oxyde d'indium ;

c) une troisième étape de gravure des couches de métal et d'oxyde d'indium de façon à réaliser dans ces couches des électrodes de lignes, des éléments d'images, et des éléments d'électrodes de colonnes non situés dans des zones d'intersections de lignes et de colonnes ;

d) une quatrième étape de dépôt d'une couche d'un matériau isolant sur l'ensemble ainsi obtenu ;

e) une cinquième étape de dépôt d'une couche d'un matériau semiconducteur amorphe ;

f) une sixième étape de dépôt d'une couche d'un deuxième matériau semiconducteur dopé de type $n+$

g) une septième étape de gravure dans ces deux couches de matériaux semiconducteurs de mésas situés à des croisements de lignes et de colonnes et chevauchant partiellement chacune une électrode de ligne ;

h) une huitième étape d'enlèvement par gravure de la couche de matériau isolant et de la première couche de métal aux emplacements suivants :

- sur la quasi totalité de la surface de chaque élément d'image ;
- sur chaque électrodes de ligne de part et d'autre de chaque croisement de lignes et de colonnes sur des surfaces de dimensions déterminées marquant l'emplacement d'interconnexions d'électrodes de lignes ;
- à chaque extrémité des éléments d'électrodes de colonnes sur des surfaces de dimensions déterminées marquant l'emplacement d'interconnexions d'électrodes de colonnes ;

i) une neuvième étape de réalisation d'une deuxième couche de métal sur l'ensemble ainsi obtenu .

J) une dixième étape de gravure dans cette deuxième couche de métal :

- d'électrodes de colonnes englobant les interconnexions de colonnes et chevauchant des mésas ;
- de connexions métalliques reliant chaque mésa à un élément d'image;
- d'éléments d'électrodes de ligne reliant deux interconnexions d'électrodes de lignes situés entre deux croisements de lignes et de colonnes ;
- cette dite gravure permettant en outre de graver la couche de semiconducteur dopée de type $n+$ en autoalignement avec l'électrodes de colonnes et lesdites connexions métalliques.

k) une onzième étape de finition d'un écran comportant les opérations suivantes :

- dépôt d'une couche d'ancrage ;
- mise en place de cales d'épaisseur ;
- réalisation d'une contre lame avec contre électrode transparente recouverte d'une couche d'ancrage ;
- mise en place d'un cristal liquide.

Les différents objets et caractéristiques de l'invention apparaîtront plus clairement dans la description qui va suivre faite en se reportant aux figures annexées qui représentent :

- la figure 1, une vue en perspective d'un exemple de réalisation d'un écran à cristal liquide selon l'art connu ;
- la figure 2, une vue générale d'un exemple de réalisation de l'écran à cristal liquide selon l'invention ;
- la figure 3 à 15, différentes étapes du procédé de l'écran à cristal liquide selon l'invention.

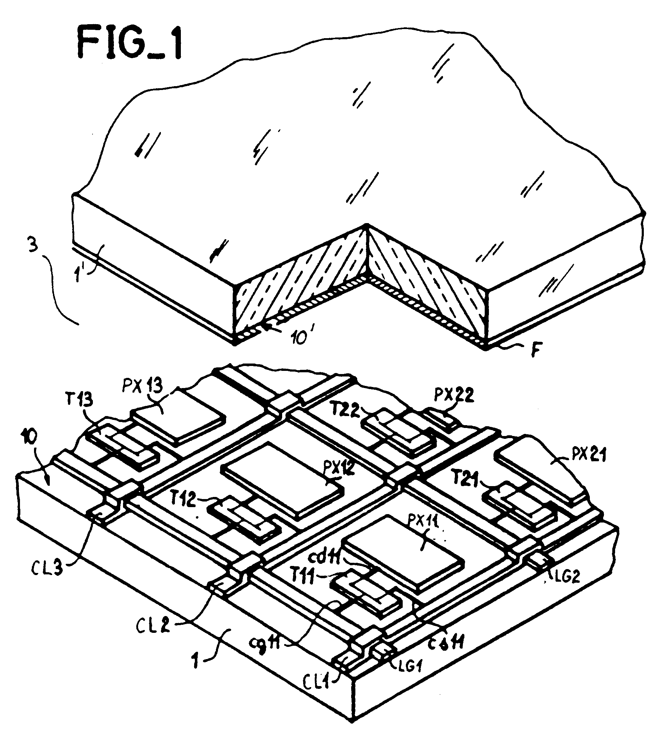

En se reportant à la figure 1, on va tout d'abord décrire un exemple d'écran à cristal liquide connu dans la technique tel que décrit par exemple dans les demandes de brevets français n° 85 12804 ou n° 8516935.

Sur cette figure on trouve sur une face 10 d'une première lame 1 les conducteurs de ligne LG1 et LG2, les conducteurs de colonnes CL1, CL2 et CL3. Connectés sensiblement à chaque point de croisement, on trouve également des transistors et des éléments images, tels que le transistor T11 l'élément image PX 11 situés au croisement du conducteur de ligne LG1 et du conducteur de colonne CL1.

Une deuxième lame 1, de préférence en verre, détermine avec une de ces faces 10' et la face 10 de la lame 1, un espace dans lequel est placé un cristal liquide CX.

La lame 1' est transparente et possède au moins une électrode F. Un élément image de la face 10 telle que PX 11, la lame 1' en vis-à-vis et le cristal liquide qui les séparent constituent une cellule à cristal liquide de l'écran.

Le fonctionnement d'un tel écran est connu. Rappelons simplement que pour afficher une information sur une cellule de cristal liquide, il faut appliquer à une ligne (LG1 par exemple) et une colonne (CL1 par exemple) des potentiels appropriés rendant conducteur le transistor T11 qui applique alors un potentiel à l'élément PX11 de telle façon que l'élément d'image PX11 de la cellule CL11 soit soumis à une différence de potentiel permettant un changement d'état du cristal liquide.

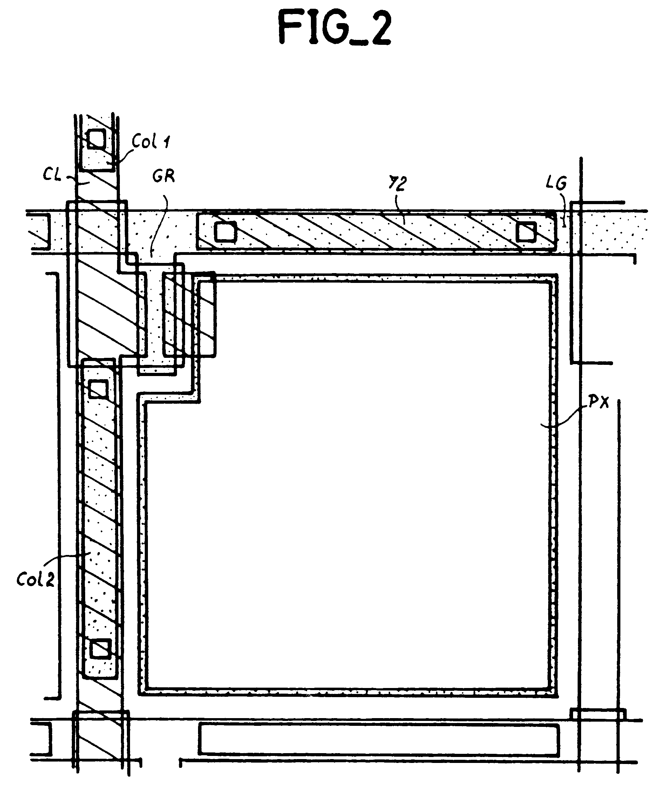

En se reportant aux figures 2, 13, 14 et 15, on va décrire un exemple de réalisation d'un écran à cristal liquide selon l'invention.

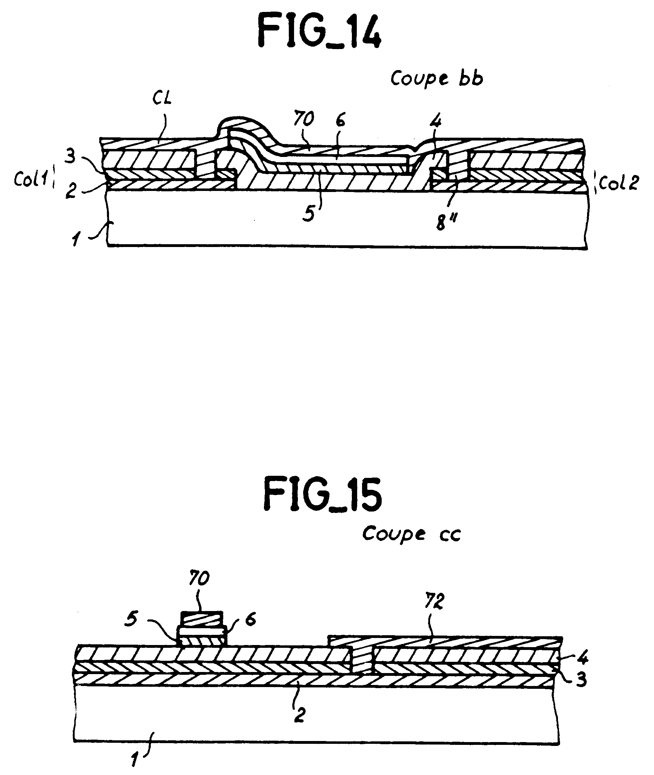

Cet écran comporte disposés sur une face 10 d'une plaque de substrat 1 :
- des électrodes de lignes LG visibles en figure 15 ;
- des éléments d'électrodes de colonnes col.1 et col.2, visibles notamment en figures 14, qui sont interrompus avant d'atteindre chaque point de croisement avec une électrode de ligne LG. ;
- des éléments d'image PX disposés à proximité de chaque point de croisement de l'écran à cristal liquide.

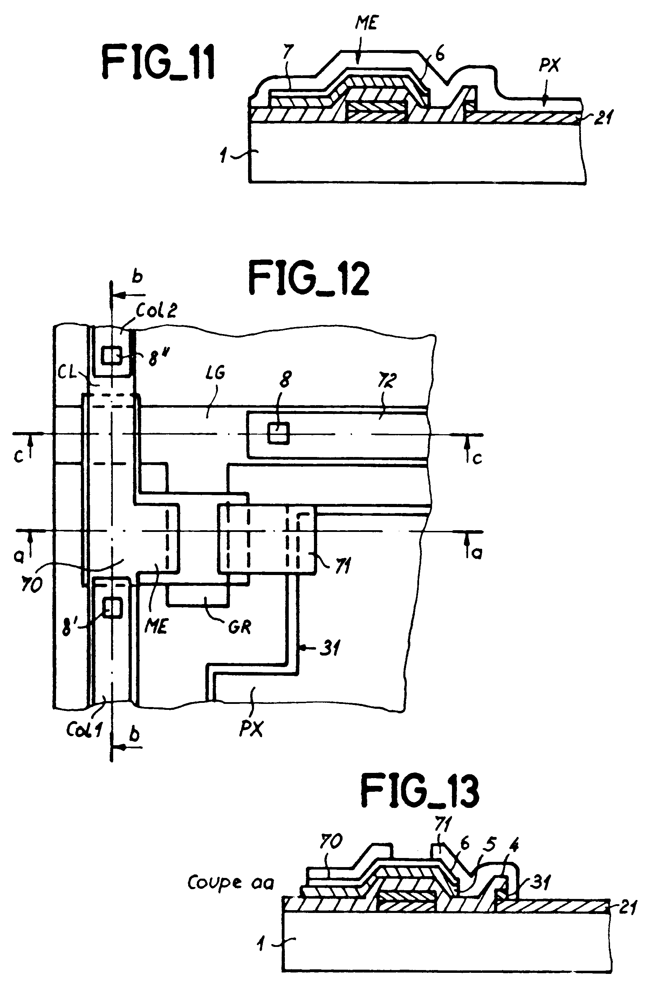

Les électrodes de lignes LG et les éléments d'électrodes de colonnes col.1 et col.2 sont constituées d'une couche (2) d'oxyde d'indium-étain (ITO) et d'une couche métallique (3).les éléments d'images PX sont en oxyde d'indium-étain.
Pour des raisons de contacts à réaliser ils peuvent avoir une faible partie (31 sur la figure 13) notamment le pourtour, recouvert d'une couche métallique.

Les électrodes de lignes LG possèdent à proximité de chaque élément d'image, une dent GR qui servira de grille au transistor de commande de cet élément d'image.

La couche métallique 3 ainsi que la surface de l'écran non occupée par les éléments d'image est recouverte d'une couche d'isolant 4.

Comme cela est représenté en figures 14 et 15 des plots de connexion traversent cette couche d'isolant et sont connectés à la couche d'oxyde d'indium 2 et la couche métallique 3 des électrodes de lignes et des éléments d'électrodes de colonnes en des emplacements situés de part et d'autre des points de croisement des lignes et des colonnes.

Sur la couche d'isolant, à chaque point de croisement se trouve une mésa ME ou plot en matériau semiconducteur recouvrant la dent GR de l'électrode de ligne se trouvant à ce point de croisement et s'étendant vers l'électrode de colonne de ce point de croisement.Cette mésa ME est constituée d'une couche 5 en semiconducteur amorphe tel que du silicium amorphe et d'une couche 6 en semiconducteur, tel que du silicium, fortement dopé de type n+.La couche 5 de semiconducteur peut être également électriquement compensée ou même faiblement dopée de type p pour en éliminer la photoconductivité et limiter l'influence de la lumière sur les caractéristiques des transistors.

Cette mésa peut s'étendre jusqu'au point de croisement ligne/colonne et avoir, comme cela est représenté en figure 2, la forme d'un "L" pour améliorer l'isolation du point de croisement ligne/colonne.

Au dessus des éléments d'électrodes de colonnes col.1 et col.2, se trouvent des électrodes de colonnes CL. A l'emplacement de chaque mésa ME, chaque électrode de colonne possède une dent DR débordant légèrement sur la dent GR de l'électrode de ligne LG. Cette dent DR constitue le drain du transistor.

Chaque électrode de colonne est connectée aux plots de connexion tel que 8' et 8″. De cette façon comme on le voit sur les figures 2 et 14, chaque électrode de colonne est dédoublée, entre chaque point de croisement, par des éléments d'électrodes de colonnes col.1 et col.2.

Chaque mésa est reliée à un élément d'image par un élément métallique 71 constituant la source S0 du transistor de commande d'un point de croisement. Cet élément métallique déborde légèrement sur la dent GR de l'électrode de ligne.

La couche de silicium 6 fortement dopée n+ est interrompue entre le drain DR et la source S0 dans l'alignement des bords du drain et de la source.

Enfin, comme cela est représenté en figures 2 et 15, au dessus de chaque électrode de ligne LG, sur la couche d'isolant 4, des éléments d'électrodes de lignes 72 connectent les plots de connexion, tels que 8, situés entre deux points de croisement. Ainsi comme les électrodes de colonnes, les électrodes de lignes sont dédoublées entre chaque point de croisement par des éléments d'électrodes de lignes 72. On se prémunit ainsi en grande partie contre les risques de coupures des électrodes de lignes et de colonnes. De plus, les reprises de connexions aux extrémités des électrodes pourront se faire de la même façon que ce soit pour les électrodes de lignes que pour les électrodes de colonnes.

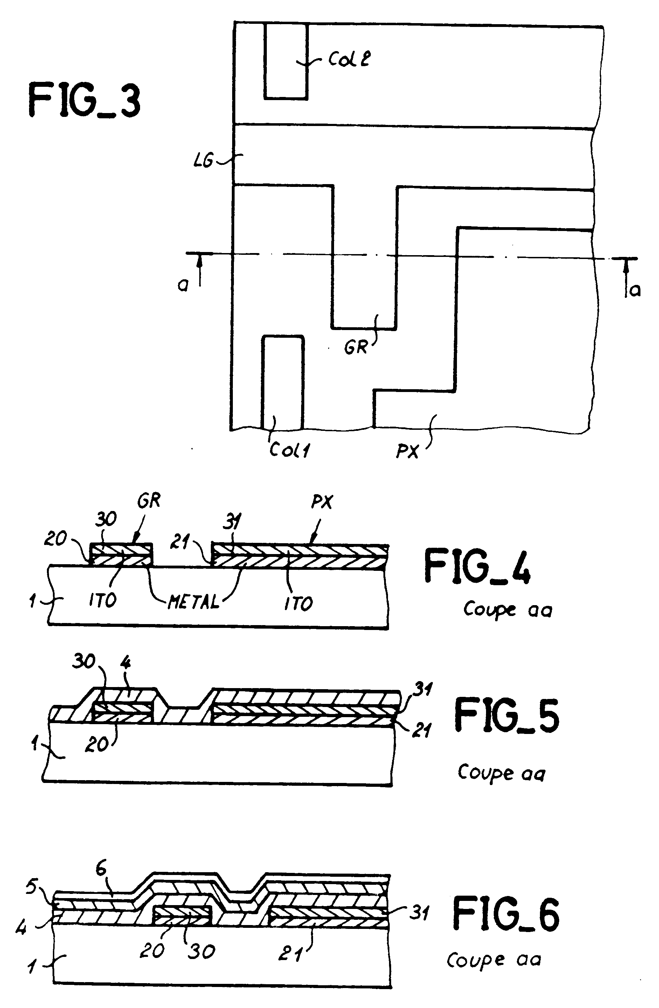

Le procédé selon l'invention permettant de réaliser cet écran de visualisation va maintenant être décrit en se reportant aux figures 3 à 15.

Au cours d'une première étape on réalise sur une face 10 d'un substrat 1, une couche d'oxyde d'indium-étain qu'on oxyde puis que l'on recuit à haut température. Un tel substrat recouvert d'une couche d'oxyde d'indium-étain (ITO) se trouve dans le commerce. Il convient donc de le recuire à haute température.

Au cours d'une deuxième étape on réalise, sur la couche d'oxyde, une couche de métal.

Au cours d'une troisième étape, on enlève par gravure l'oxyde d'indium-étain et le métal de façon à réaliser les électrodes de lignes LG avec leurs dents (GR), des éléments d'électrodes de colonnes col.1 et col.2 n'atteignant pas les électrodes de lignes LG et les éléments d'images PX. On obtient ainsi une configuration telle que représentée par les figures 3 et 4.

Au cours d'une quatrième étape, représentée en figure 5, on réalise le dépôt d'une couche de matériau isolant 4 sur l'ensemble obtenu à l'issue de la troisième étape.

Au cours d'une cinquième étape, on réalise sur la couche 4, une couche 5 d'un matériau semiconducteur amorphe. Au cours de cette étape, cette couche peut-être électriquement compensée ou légèrement dopé P pour diminuer la photoconductivité et limiter l'influence de la lumière sur les caractéristiques du transistor.

Au cours d'une sixième étape, on réalise une couche 6 d'un matériau semiconducteur fortement dopé n+.

On obtient ainsi une structure telle que représentée en figure 6.

La réalisation des couches 5 et 6 peut se faire par une méthode de dépôt telle que décharge électroluminescente ou pulvérisation réactive.

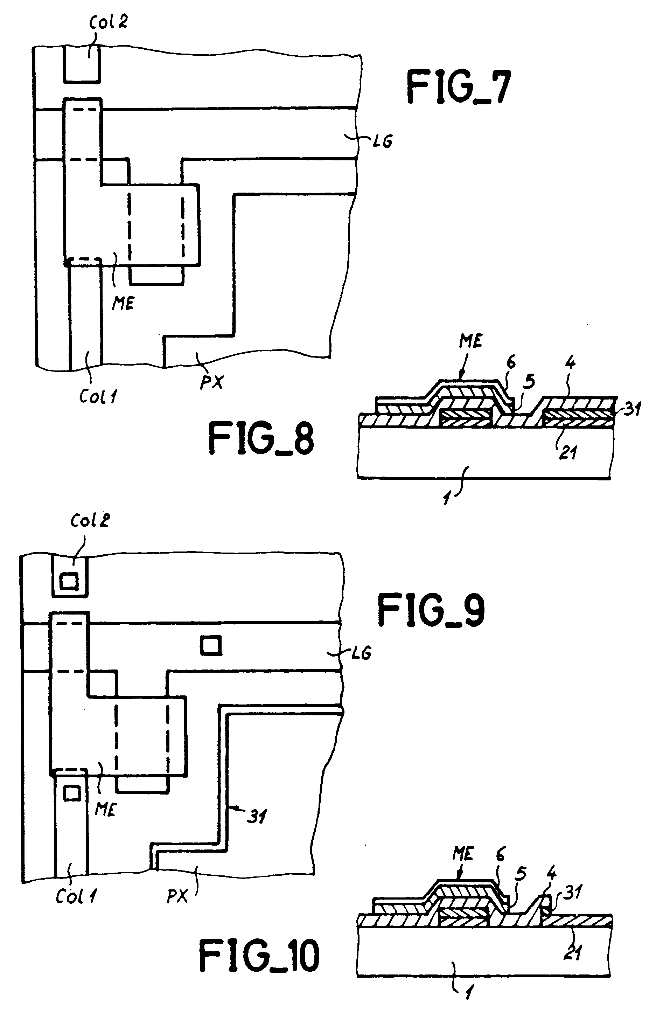

Au cours d'une septième étape, les deux couches de matériaux semiconducteurs 5 et 6 sont gravées de façon à réaliser des mésas ME (ou plots) tel que cela est représenté en figure 7 et 8. Chaque mésa recouvre une dent GR d'une électrode de ligne LG et s'étend dans une zone située dans l'alignement des éléments d'électrodes de colonnes col.1 et col.2. Cette mesa peut avoir la forme d'un L pour s'étendre jusqu'au point de croisement ligne/colonne le plus proche.

Au cours d'une huitième étape, on grave la couche d'isolant 4 et la couche de métal 3 pour dégager les éléments images PX des matériaux qui les recouvrent. Une faible partie d'isolant et de métal 31 peut être conservée sur chaque élément image, sur le pourtour par exemple comme cela est représenté en figure 9, pour faciliter des connexions électriques ultérieures.

Au cours de cette étape de gravure de l'isolant 4 et de la couche de métal 3, on dégage également des plages de connexion 8, 8', 8", à l'emplacement des électrodes de lignes et des éléments d'électrodes de colonnes et cela de part et d'autre des points de croisement. Les figures 9 et 10 illustrent la structure ainsi obtenue.

Au cours d'une neuvième étape on réalise une couche de métal 7 sur l'ensemble la structure des figures 9 et 10 et on obtient la structure de la figure 11.

Au cours d'une onzième étape, on grave la couche de métal 7 et, en ce qui concerne chaque mésa, la couche 6 de semiconducteur dopé n+, de façon à réaliser les électrodes de colonne (CL) possédant à l'emplacement de chaque mésa une dent DR recouvrant partiellement la mésa et empiétant légèrement sur la zone occupée par la dent GR.

De plus, au cours de cette étape, des connexions métalliques telles que S0, relient chaque mésa, en empiétant légèrement la zone occupée par la dent GR, à un élément image PX. La portion de métal 31 mentionnée précédemment facilite alors la connexion électrique.

Enfin des éléments d'électrodes de lignes 72 sont réalisés de façon à dédoubler les électrodes de lignes LG et à être connectées à celles-ci par les plots de connexion tels que 8.

On obtient ainsi un composant représenté par les figures 2, et 12 à 15.

Au cours d'une onzième étape on termine la réalisation de l'écran à cristal liquide selon des techniques connues en prévoyant des opérations de :
- dépôt de couche d'ancrage ;
- mise en place de cales d'épaisseur ;
- réalisation d'une contre lame avec contre-électrode transparente recouverte d'une couche d'ancrage ;
- mise en place du cristal liquide.

L'écran à cristal liquide selon l'invention est ainsi réalisé.

Selon une variante du procédé de réalisation de l'invention, on prévoit d'effectuer la découpe des mésas, telles que ME prévue à la septième étape au cours d'une étape située entre la dixième et la onzième étapes. Dans ce cas, il est nécessaire au cours de la huitième étape consistant en une gravure de la couche d'isolant 4 de graver les couches de matériau semiconducteur 5 et 6 de façon à dégager la couche de métal 3.

Il est bien évident que la description qui précède n'est pas limitative et que d'autres variantes d'écrans de visualisation et de procédés de réalisation peuvent être envisagés sans sortir du cadre de l'invention telle que revendiquée.

**Revendications**

1. Ecran de visualisation électrooptique à transistors de commande comportant :
   - une première et une deuxième lames parallèles (1, 1′) enserrant un matériau électrooptique (CX) ;
   - la première lame (1) étant munie sur sa face (10) en contact avec le matériau électrooptique (CX) d'une matrice d'éléments image (PX11 à PX22) arrangés en lignes et colonnes, d'électrodes de commande de ligne (LG1, LG2) à raison d'une électrode associé à chaque ligne d'éléments image de ladite matrice et disposée parallèlement à cette ligne d'éléments image, et de transistors de commande (T11 à T22) à raison d'un transistor par élément image (PX11 à PX22 ) couplant celui-ci à ladite électrode de commande de ligne ;
   - la deuxième lame (1′) étant munie sur sa face (10′) en contact avec le matériau électrooptique (C) d'au moins une électrode F ;
   caractérisé en ce qu'il comporte en outre sur la première lame .
   - des éléments d'électrodes de colonnes interrompus à chaque croisement d'une ligne et d'une colonne ;
   - une couche de matériau isolant (4) recouvrant la face (10) de la première lame (1) dans les zones non couvertes par les électrodes de lignes, les éléments d'électrodes de colonnes et les éléments image, et recouvrant aussi les électrodes de lignes et les éléments d'électrodes de colonnes sauf des zones d'interconnexion (8, 8′, 8″) situées au voisinage de chaque point de croisement de ligne et colonne;
   - une mésa (ME) par point de croisement de ligne et de colonne en matériau semiconducteur recouvrant une partie d'une électrode de ligne (LG) ;
   - un élément conducteur (71) (ou drain de transistor) reliant la mésa à l'élément image ;
   - au moins une électrode de colonnes reliée à la mésa et connectée par les zones d'interconnexion (8′, 8″) aux éléments d'électrodes de colonne ;
   - des éléments d'électrodes de lignes superposés à la couche de matériau isolant (4), interrompus à chaque croisement d'un ligne et d'une colonne et connectés par les zones d'interconnexion (8) aux électrodes de lignes (LG) situées de l'autre côté de la couche d'isolant (4).

2. Procédé de réalisation d'un écran de visualisation électrooptique à transistors de commande selon la revendication 1, comportant les étapes suivantes :
   a) une première étape de dépôt d'un couche d'oxyde d'indium sur une face (10) d'un substrat (1), d'oxydation de cette couche, puis de recuit à haute température.
   b) une deuxième étape de dépôt d'une première couche de métal sur ladite couche d'oxyde d'indium ;
   c) une troisième éta pe de gravures des couches de métal et d'oxyde d'indium de façon à réaliser dans ces couches des électrodes de lignes (LG), des éléments d'images (PX), et des éléments d'électrodes de colonnes (CL1, CL2) non situés dans des zones d'intersections de lignes et de colonnes ;
   d) une quatrième étape de dépôt d'une couche d'un matériau isolant (4) sur l'ensemble ainsi obtenu ;
   e) une cinquième étape de dépôt d'une couche d'un premier matériau semiconducteur amorphe (5) ;
   f) une sixième étape de dépôt d'une couche d'un deuxième matériau semiconducteur (6) dopé de type n + ;
   g) une septième étape de gravure dans ces deux couches de matériaux semiconducteurs (5 et 6) de mésas (ME) situées à des croisements de lignes et de colonnes et chevauchant partiellement chacune une électrode de ligne ;
   h) une huitième étape d'enlèvement par gravure de la couche de matériau isolant 4 et de la première couche de métal aux emplacements suivants :
      - sur la quasi totalité de la surface de chaque élément d'image PX ;

- sur chaque électrodes de lignes (LG) de part et d'autre de chaque croisement de lignes et de colonnes sur des surfaces de dimensions déterminées marquant l'emplacement d'interconnexions d'électrodes de lignes (8) ;
- à chaque extrémité des éléments d'électrodes de colonnes (CL1, CL2) sur des surfaces de dimensions déterminées marquant l'emplacement d'interconnexions d'électrodes de colonnes (8′, 8″) ;

i) une neuvième étape de réalisation d'une deuxième couche de métal (7) sur l'ensemble ainsi obtenu ;

j) une dixième étape de gravure dans cette couche de métal (7):
- d'électrodes de colonnes (70) englobant les interconnexions de colonnes (8′, 8″) et chevauchant des mésas (ME) ;
- de connexions métalliques (71) reliant chaque mésa (ME) à un élément d'image (PX) ;
- d'éléments d'électrodes de ligne (72) reliant deux interconnexions d'électrodes de lignes (8) situés entre deux croisements de lignes et de colonnes ;
- cette dite gravure permettant en outre de graver la couche de semiconducteur (6) dopée de type n + en autoalignement avec les électrodes de colonnes (70) et lesdites connexions métalliques (71) ;

k) une onzième étape de finition d'un écran comportant les opérations suivantes :
- dépôt d'une couche d'ancrage ;
- mise en place de cales d'épaisseur ;
- réalisation d'une contre lame avec contre électrode transparente recouverte d'une couche d'ancrage ;
- mise en place d'un cristal liquide ;

3. Procédé de réalisation selon la revendication 2, caractérisé en ce qu'au cours de la troisième étape les électrodes de lignes sont gravées de façon à posséder des dents (GR) dirigées vers les éléments d'images (PX) et, qu'au cours de la septième étape, les mésas sont gravés de façon à chevaucher ces dents (GR).

4. Procédé selon la revendication 2, caractérisé en ce que les deuxième et neuvième étapes de dépôt de métal sont réalisées par évaporation ou pulvérisation cathodique.

5. Procédé selon la revendication 2, caractérisé en ce qu'au cours de la cinquième étape la couche de semiconducteur amorphe est électriquement compensée ou faiblement de type n afin d'en diminuer la photoconductivité et de limiter l'influence de la lumière sur les caractéristiques du transistor.

6. Procédé selon la revendication 2, caractérisé en ce qu'au cours de la septième étape, chaque mésa (ME) réalisée recouvre également la zone d'isolant se trouvent à une intersection ligne et colonne.

7. Procédé selon la revendication 2, caractérisé en ce que la septième étape de gravure de mésas (ME) est réalisée entre la dixième étape et la onzième étape et en ce qu'au cours de la huitième étape on grave également les couches (5, 6) de matériau semiconducteur.

**Claims**

1. A transistor-driven electro-optical display screen comprising
- a first and a second blade (1, 1') which are mutually parallel and encompass an electro-optical material (CX),
- the first blade (1) being supplied on its face (10) contacting the electro-optical material (CX) with a matrix of picture elements (PX11 to PX22) arranged in lines and columns, with line control electrodes (LG1, LG2), one electrode being associated respectively to each line of picture elements of said matrix and being disposed parallelly to this line of picture elements, and with control transistors (T11 to T22), one transistor respectively for each picture element (PX11 to PX22) being intended to couple the latter to said line control electrode,
- the second blade (1') being supplied on its face (10') contacting the electro-optical material (CX) with at least one electrode (F), characterized in that it further comprises on the first blade
- elements of control electrodes interrupted at each intersection of a line and a column,
- an insulating layer (4) covering the face (10) of the first blade (1) in zones which are not covered by the line electrodes, the elements of column electrodes and the picture elements, and further covering the line electrodes and the elements of column electrodes except the interconnection zones (8, 8', 8") situated close to each intersection point of lines and columns,
- one mesa (ME) respectively for each intersection point of lines and columns, said mesa being made of semiconductor material and covering a portion of a line electrode (LG),
- a conducting element (71) (or transistor drain) for connecting the mesa to the picture element,
- at least one column electrode connected to the mesa and connected via the interconnection zones (8', 8") to the elements of column electrodes,
- elements of line electrodes overlaying the layer of insulating material (4), interrupted at each intersection between a lign and a column and connected via the interconnection zones (8) to the line electrodes (LG) located on the other side of the insulating layer (4).

2. A method of manufacturing a transistor-driven electro-optical display screen according to claim 1, said method comprising the following steps:

a) a first step in which a layer of indium oxide is deposited on one face (10) of a substrate (1), said layer then being oxidized and finally treated at high temperature,

b) a second step in which a first metal layer is deposited on said indium oxide layer,

c) a third step in which the metal and indium oxide layers are engraved in such a way that line electrodes (LG), picture elements (PX) and elements of column electrodes (CL1, CL2) not located in the intersection zones of lines and columns are realised in these layers,

d) a fourth step in which a layer of insulating material (4) is deposited on the assembly thus obtained,

e) a fifth step in which a layer of a first amorphous semiconductor material (5) is deposited,

f) a sixth step in which a layer of a second semiconductor material (6) which is n+ doped is deposited,

g) a seventh step in which mesas (ME) are realised by etching in these two semiconductor layers (5 and 6), these mesas being situated at intersections of lines and columns and each partially overlaying one line electrode,

h) an eighth step in which the insulating layer (4) and the first metal layer are withdrawn by etching from the following zones:
- on nearly the entire surface of each picture element (PX),

- on each line electrode (LG) on either side of each intersection of lines and columns, this etchingtaking place in areas of predetermined size which mark the location of line electrode interconnections (8),
- at each end of the elements of column electrodes (CL1, CL2) in areas of predetermined size which mark the location of column electrode interconnections (8', 8"),

i) a nineth step in which the assembly thus obtained is coated by a second metal layer (7),

j) a tenth step in which this metal layer (7) is engraved in order to obtain
- column electrodes (70) including the column interconnections (8', 8") and overlapping the mesas,
- metal connections (71) for connecting each mesa (ME) to a picture element (PX),
- elements of line electrodes (72) interconnecting two line electrode interconnections (8) situated between two line and column intersections,
- this engraving operation further allowing to engrave the semiconductor layer (6) which is n+ doped in self-alignment with the column electrodes (70) and said metal connections (71),

k) an eleventh step of screen termination comprising the following operations:
- depositing an anchoring layer,
- positioning distance pieces,
- realising a counter-blade with a counter-electrode which is transparent and is covered by an anchoring layer,
- putting a liquid crystal inplace.

3. A manufacturing method according to claim 2, characterized in that during the third step, the line electrodes are etched in such a way that they present teeth (GR) pointing towards the picture elements (PX), and that during the seventh step, the mesas are engraved in such a way that they overlap these teeth (GR).

4. A method according to claim 2, characterized in that the second and nineth step of depositing a metal make use of evaporation or cathode sputtering techniques.

5. A method according to claim 2, characterized in that during the fifth step, the amorphous semiconductor layer is electrically compensated or slightly n doped in order to reduce the photoconductivity and to restrict the influence of light on the characteristics of the transistor.

6. A method according to claim 2, characterized in that during the seventh step, each manufactured mesa (ME) further covers the zone of insulating material situated at an intersection between line and column.

7. A method according to claim 2, characterized in that the seventh step of realising the mesas (ME) is performed between the tenth and the eleventh step and that during the eighth step, the semiconductor layers (5, 6) are also etched.

**Patentansprüche**

1. Transistorgesteuerter elektro-optischer Bildschirm
   - mit einer ersten und einer zweiten Lamelle (1, 1'), die zueinander parallel sind und zwischen sich ein elektro-optisches Material (CX) einschließen,
   - wobei die erste Lamelle (1) auf ihrer mit dem elektro-optischen Material (CX) in Kontakt stehenden Oberseite (10) eine Matrix von in Zeilen und Spalten angeordneten Bildelementen (PX11 bis PX22), Zeilensteuerelektroden (LG1, LG2), und zwar eine parallel zu dieser Zeile von Bildelementen verlaufende Elektrode für jede Zeile von Bildelementen der Matrix, und Steuertransistoren (T11 bis T22) aufweist, und zwar einen Transistor pro Bildelement (PX11 bis PX22), der dieses Bildelement an die Zeilensteuerelektrode koppelt,
   - wobei die zweite Lamelle (1') auf ihrer mit dem elektrooptischen Material (CX) in Berührung stehenden Oberseite (10') mindestens eine Elektrode (F) besitzt, dadurch gekennzeichnet, daß der Bildschirm weiter auf der ersten Lamelle aufweist:
   - Elemente von Spaltenelektroden, die an jedem Kreuzungspunkt einer Zeile und einer Spalte unterbrochen sind,
   - eine Schicht aus Isoliermaterial (4), die die Oberseite (10) der ersten Lamelle (1) in den nicht von den Zeilenelektroden, den Elementen der Spaltenelektroden und den Bildelementen bedeckten Zonen überdeckt und außerdem die Zeilenelektroden und die Elemente der Spaltenelektroden überdeckt, mit Ausnahme der Anschlußzonen (8, 8', 8"), die sich in der Nähe jedes Kreuzungspunkts von Zeile und Spalte befinden,
   - einen Tafelberg (ME) je Kreuzungspunkt zwischen Zeile und Spalte, wobei der Tafelberg aus Halbleitermaterial besteht und einen Teil einer Zeilenelektrode (LG) bedeckt,
   - ein Leitelement (71) (oder Transistordrain), das den Tafelberg mit dem Bildelement verbindet,
   - mindestens eine Spaltenelektrode, die an den Tafelberg sowie über die Anschlußzonen (8', 8") an die Elemente von Spaltenelektroden angeschlossen ist,
   - Elemente von Zeilenelektroden, die über der Schicht aus Isoliermaterial (4) angeordnet sind und an jedem Kreuzungspunkt einer Zeile mit einer Spalte unterbrochen sowie über die Anschlußzonen (8) an die Zeilenelektroden (LG) angeschlossen sind, die auf der anderen Seite der Isolierschicht (4) liegen.

2. Verfahren zur Herstellung eines transistorgesteuerten elektro-optischen Bildschirms nach Anspruch 1, das folgende Verfahrensschritte aufweist:
   a) einen ersten Verfahrensschritt, in dem eine Schicht aus Indiumoxid auf eine Oberseite (10) eines Substrats (1) aufgebracht, dann oxidiert und schließlich bei hoher Temperatur ausgeheizt wird,
   b) einen zweiten Verfahrensschritt, in dem eine erste Metallschicht auf die Indiumoxidschicht aufgebracht wird,
   c) einen dritten Verfahrensschritt, in dem die Schichten aus Metall und Indiumoxid geätzt werden, derart, daß in diesen Schichten Zeilenelektroden (LG), Bildelemente (PX) und nicht in den Kreuzungszonen von Zeilen und Spalten liegende Elemente von Spaltenelektroden (CL1, CL2) gebildet werden,
   d) einen vierten Verfahrensschritt, in dem eine Schicht aus Isoliermaterial (4) auf die so erhaltene Einheit aufgebracht wird,
   e) einen fünften Verfahrensschritt, in dem eine Schicht eines ersten amorphen Halbleitermaterials (5) aufgebracht wird,
   f) einen sechsten Verfahrensschritt, in dem eine Schicht aus einem zweiten Halbleitermaterial (6) aufgebracht wird, das vom Typ n + dotiert ist,
   g) einen siebten Verfahrensschritt, in dem durch Ätzen dieser beiden Schichten aus Halbleitermaterial (5 und 6) Tafelberge (ME) gebildet werden, die an den Kreuzungspunkten von Zeilen und Spalten liegen und teilweise über je eine Zeilenelektrode ragen,
   h) einen achten Verfahrensschritt, in dem durch Ätzen die Schicht aus Isoliermaterial (4) und die erste Metallschicht an den folgenden Stellen entfernt wird:

- auf der nahezu vollständigen Oberfläche jedes Bildelements (PX),
- auf jeder Zeilenelektrode (LG) zu beiden Seiten jedes Kreuzungspunkts zwischen Zeilen und Spalten auf Flächen vorbestimmter Abmessungen, die die Anschlußstellen der Zeilenelektroden (8) markieren,
- an jedem Ende der Elemente von Spaltenelektroden (CL1, CL2) und zwar auf Flächen bestimmter Abmessungen, die die Anschlußstellen der Spaltenelektroden (8', 8") markieren,

i) einen neunten Verfahrensschritt, in dem eine zweite Metallschicht (7) auf die so erhaltene Einheit aufgebracht wird,

j) einen zehnten Verfahrensschritt, in dem durch Ätzen dieser Metallschicht (7) gebildet werden:

- Spaltenelektroden (70), die die Spaltenanschlüsse (8', 8") einschließen und sich bis auf die Tafelberge (ME) erstrecken,
- metallische Anschlüsse (71), die jeden Tafelberg (ME) mit einem Bildelement (PX) verbinden,
- Elemente von Zeilenelektroden (72), die zwei Zeilenelektrodenanschlüsse (8) miteinander verbinden und zwischen zwei Kreuzungspunkten von Zeilen und Spalten liegen,
- wobei dieser Ätzvorgang es außerdem ermöglicht, die vom Typ n+ dotierte Halbleiterschicht (6) in Selbstausrichtung mit den Spaltenelektroden (70) und den metallische Anschlüssen (71) herauszubilden,

k) einen elften Verfahrensschritt, in dem der Bildschirm fertiggestellt wird und der folgende Operationen umfaßt:

- Aufbringen einer Verankerungsschicht,
- Anbringen von Abstandsstücken,
- Herstellung einer Gegenlamelle mit einer Gegenelektrode, die transparent und mit einer Verankerungsschicht bedeckt ist,
- Einbringen eines Flüssigkristalls.

3. Verfahren zur Herstellung nach Anspruch 2, dadurch gekennzeichnet, daß während des dritten Verfahrensschritts die Zeilenelektroden durch Gravieren derart hergestellt werden, daß sie Zähne (GR) aufweisen, die zu den Bildelementen (PX) hin zeigen, und daß während des siebten Verfahrensschritts die Tafelberge durch Ätzen hergestellt werden, derart, daß sie sich über diese Zähne (GR) erstrecken.

4. Verfahren nach Anspruch 2, dadurch gekennzeichnet, daß der zweite Verfahrensschritt und der neunte Verfahrensschritt, in denen Metallschichten aufgebracht werden, durch Verdampfung oder Kathodenzerstäubung erfolgen.

5. Verfahren nach Anspruch 2, dadurch gekennzeichnet, daß während des fünften Verfahrensschritts die Schicht aus amorphem Halbleitermaterial elektrisch kompensiert oder gering vom Typ n dotiert wird, um die Fotoleitfähigkeit zu verringern und den Einfluß des Lichts auf die Kennwerte des Transistors zu begrenzen.

6. Verfahren nach Anspruch 2, dadurch gekennzeichnet, daß jeder während des siebten Verfahrensschritts hergestellte Tafelberg (ME) außerdem die Isolierzone überdeckt, die sich am Kreuzungspunkt einer Zeile und einer Spalte befindet.

7. Verfahren nach Anspruch 2, dadurch gekennzeichnet, daß der siebte Verfahrensschritt mit der Herstellung der Tafelberge (ME) zwischen dem zehnten und dem elften Verfahrensschritt erfolgt, und daß während des achten Verfahrensschritts außerdem die Schichten (5, 6) aus Halbleitermaterial geätzt werden.

# FIG_1

EP 0 266 252 B1

# FIG_2

12

## FIG_3

Col 2

LG

a

GR

a

Col1    PX

## FIG_4

Coupe aa

GR    PX
30    31
20    21
1    ITO    METAL    ITO

## FIG_5

Coupe aa

30    4
31
21
1    20

## FIG_6

Coupe aa

6
5
4
31
1    20    30    21

Col 2

FIG_7

LG

ME

PX

Col 1

FIG_8

ME  6  5  4

31

21

1

Col 2

FIG_9

LG

ME

31

ME

31

Col 1

PX

FIG_10

ME  6  5  4

31

21

1

14

# FIG_11

ME
7  6  PX
1  21

# FIG_12

b
Col 2
8"
CL
LG  8  72
c  c
71
a  a
70
8'  ME  GR
31
Col 1  b
PX

# FIG_13

70  71  6  5  4
Coupe aa  31
21
1

EP 0 266 252 B1

# FIG_14

Coupe bb

# FIG_15

Coupe cc